# NEW EUROPEAN PATENT SPECIFICATION

(11) **EP 0 787 582 B2**
(45) Date of publication and mention of the opposition decision: **22.06.2011**
(45) Mention of the grant of the patent: 04.06.2003
(21) Application number: 96111162.2
(22) Date of filing: 11.07.1996
(51) Int. Cl.: B32B 15/08, B32B 27/32, C23C 14/20, B65D 65/40, B65D 65/42

(54) **Process for printing and/or laminating a metallized polypropylene film and film obtained thereby**
Verfahren zum Bedrucken und/oder Kaschieren einer metallisierten Polypropylenfolie und danach hergestellte Folie
Procédé pour imprimer et/ou laminer une pellicule en polypropylène métallisée et pellicule ainsi obtenue

(30) Priority: 26.01.1996 IT MI960132
(43) Date of publication of application: 06.08.1997
(73) Proprietor: Bimo Italia S.p.A., Atessa (Chieti) (IT)
(72) Inventor: Scarati, Mario Alberto, 20154 Milano (IT); Del Lupo, Angelo, 66054 Vasto (Chieti) (IT)
(74) Representative: Sama, Daniele

(56) References cited:
- EP-A- 0 282 917
- EP-A- 0 329 336
- EP-A- 0 402 100
- EP-A- 0 524 725
- EP-A- 0 611 647
- EP-A- 0 669 348
- EP-A1- 0 021 672
- WO-A1-97/11846
- DE-A- 3 008 422
- US-A- 4 345 005
- US-A- 4 487 871
- US-A- 4 681 804
- US-A- 4 888 237
- US-A- 5 049 436
- 'SPE, Polyolefins IX. Conference Proceedings 25th Feb. - 1st March, 1995', 1995, SHELL DEVELOPMENT CO. - CORPORATE EDITOR SPE, HOUSTON, TX, USA article CAMBELL, R.N., CHATTERJEE, A.M.: 'Cefor Propylene-Butene Randon Copolymers for Cast and Oriented Film Applications', pages 227 - 245

## Description

The present invention relates to printed and/or laminated metallized plastic films having improved adhesion between the metal layer and the printed layer and/or laminated layer.

It is known in the art that, to make a plastic film printable, its surface must be treated with high frequency discharges (corona discharge), flame treatment, plasma discharge.

It has been found with these treatments that the surface of the plastic film allows in general an improved adhesion of inks and adhesives.

It is also known in the art to obtain plastic films for the applications indicated above showing good barrier characteristics to gas and water, to guarantee a good conservation of packed food, as well as good opacity characteristics to U.V rays to avoid the onset of food rancidity.

In order to obtain these characteristics it is known to carry out a metallization process, for instance obtained by evaporation of aluminium under vacuum and deposition of the metal vapour onto the plastic film surface.

Also in the case of metallization the film surface must be treated with the surface treatment methods described in order to obtain a good adhesion of the metal layer to the film.

WO 95/14738 discloses compositions comprising random copolymers of propylene and butene-1 having improved optical properties, suitable for preparation of films having low hexane extractibles content. WO 95/14738 further discloses multilayered metallized films thereof in accordance with the preamble of claim 5 and a process for coextrusion such composition into films, surface treating such films and metallizing such surface treated films.
EP 524725 discloses a metallized plastic film wherein the base film may be any plastic film conventionally used in the field of wrapping films. Said metallized plastic film is claimed to show a good adhesion between the metallic layer and the base plastic film, so that peeling off of the metallic layer does not substantially occur during manufacturing or processing of the film.

EP 611647 discloses sheets for packings having good machinability and a temperature of sealing lower than 84°C. The surface layers of said sheets are made of low crystalline C₃-C₄ olefin resin composition whereas the core layer is made of propylene (co)polymers. When the propylene (co)polymer is an isotactic propylene homopolymer, it must have a quantity of heptane extractibles content equal to or lower than 6%.

The technical problem of the present invention is to provide printed and/or laminated metallized plastic film having improved adhesion between the metal layer and the printed layer and/or laminated layer after a storage period of at least 1 month of the metallized plastic film prior to being printed and/or laminated.

It is to be noted that plastic films show quick loss of their printability, due to the extreme thinness of the surface layer obtained by the corona discharge treatment or by other methods mentioned above, which is of the order of 50-100 Å.

Moreover also a slight friction or rub can "cancel". the surface treatment obtained by the methods indicated by mere damage of the surface.

However, since the material after metallization is wound in rolls, the problem of contamination of the metal in contact with the successive film layer (the so called cross-contamination) exists.

As a consequence of the foregoing, in order to improve printability and resistance to delamination, special adhesives, primers and inks are used, which lead to more expensive production processes or additional process stages.

Metallized plastic films are more affected by this negative phenomenon of contamination. Bioriented coextruded polypropylene films are specially affected. Such films essentially consist of a core layer of polypropylene homopolymer and of two surface layers consisting of a copolymer based on propylene/ethylene.

Furthermore, the above indicated properties are more rapidly compromised by storage in hot and humid climates. The Applicant has surprisingly and unexpectedly found that it is possible to obtain coextruded, bioriented, metallized films having improved resistance to delamination having and having improved printability and laminability and showing suitably stable properties for periods of storage longer than 1 month, preferably longer than 3 months, most preferably longer than 6 months.

Without being bound to any theory, it has been found indeed by the Applicant, after several tests, that the contamination discussed above (cross-contamination), can also be caused by even small amounts of waxy additives and/or residues of the polymerization process contained in the polymer or copolymer utilized for preparing films. These residues are generally characterized by very low molecular weights and are classifiable among oligomeric products.

Moreover, micrographic tests carried out by the Applicant have shown that the metal layer is always affected by microfractures. The same substances above mentioned can migrate through them and influence the nature of the metal layer.

Optionally, the copolymer based on propylene can contain also ethylene in amounts from 0 to 40% by moles, preferably from 3 to 15%, most preferably from 5 to 10%. The alpha-olefins, which are always present in the copolymer of the invention as essential components, are represented, as an example, by butene, hexene and octene in amounts generally up to 10% by moles, preferably from 0.5 to 6%. Also other comonomers can be present in the copolymer, such as cyclopentadiene and terpenes in molar amounts generally up to 10% by moles, preferably from 0 to 5%.

The MFI of the propylene copolymer can vary in a wide range, however it is preferred to use copolymers having MFI from 4 to 8 g/10 min.

The copolymers of the invention contain low amounts of oligomers, generally their extractibles in n-hexane (at 50°C for 2 hours) must be lower than 5.5% by weight, as determined according to FDA 177 1520 standard.

For instance the above described copolymers are prepared according to USP 4,254,169, or USP 3,549,389 by utilizing, as basic comonomer, propylene, or according to European patents EP 633,133, EP 669,348.

These copolymers are commercially known, for instance as EXCELLEN^{(R)} SP 68E1 or NOBLEN^{(R)} WF 825 of Sumitomo Chemical.

The core layer is a propylene homopolymer which is coextruded with the copolymer of the invention, can preferably be oriented at least in one direction, more preferably bioriented as known in the art. For instance MOPLEN^{(R)} S28F can be cited.

The MFI of the PP used as a core layer can vary in a wide range, however it is preferred to use a PP having MFI from 1 to 2 g/10 min.

Multilayer coextruded films according to the present invention are generally obtained by means of flat die coextrusion methods.

Al already said, the plastic films of he present invention are printed on its metal layer side or laminated with its metal layer onto a susbtrate, without the use of printing special inks, primers and special adhesives.

Metallization is carried out through well-known processes, such as evaporation under vacuum, sputtering, plasma deposition, etc.

The plastic films of the present invention have a total thickness ranging from 12 to 80 micron, preferably from 15 to 50 micron.

The surface layers have a thickness from 0.2 to 20 micron and preferably from 0.5 to 1.5 micron.

The coextruded film structures of the present invention have a polypropylene homopolymer core with coextruded skin layers of the copolymer of the present invention to give multilayer structures.

The metallized layer thickness generally ranges from 100 to 1000 Å, preferably from 200 to 500 Å.

The following examples are given for illustrative and not limitative purposes of the present invention.

### EXAMPLES

Plastic bioriented coextruded films made of polypropylene (homo or copolymer) were produced on a biaxial tenter frame with the following operating parameters:
longitudinal stretching ratio from 4.5 to 6
transversal stretching ratio from 6.0 to 9.

Various thicknesses were produced, on a web width of 7.0 m.

### EXAMPLE 1

### EXAMPLE 1A (comparative)

A three-layer coextruded bioriented polypropylene film having a total thickness of 25 micron, was produced by using an ethylene-propylene copolymer with M.I. = 5.6 g/10' in the skin layers (each one 0.8 µm thick).

In the core layer a polypropylene homopolymer having M.I.= 2.2 g/10', was used.

The film was surface treated with high frequency discharge (from now on called "corona discharge"), with an intensity of 50 W/cm, said film was vacuum metallized obtaining an aluminium layer thickness equal to 400 Å.

### EXAMPLE 1B

A coextruded bioriented polypropylene film having a total thickness of 25 micron, was produced by using a homopolymer of M.I. 2.1 g/10', (MOPLEN S28F) in the core layer. Extractibles in hexane, at the test indicated above, were lower than 2% by weight. The skin layers had a thickness of 0.8 microns, and were made of a copolymer with M.I. = 5.5 g/10', commercially known as EXCELLEN^{(R)} SP 68E1 of Sumitomo Chemical, having extractibles in hexane at the test indicated above lower than 2.0% by weight.

Also in this case, the film was surface treated with an intensity of 50 W/cm, then the film was vacuum metallized, with an aluminium thickness equal to 400 Å.

### FILMS CHARACTERIZATION

Surface tensions in mN/m (dyne/cm) of the aluminium layer were determined according to ASTM D 2578 standard on the manufactured materials.

The results of surface tension on the films obtained in examples 1A and 1B are reported in Table 1.

**TABLE 1**

| | FRESH (just metallized) | AFTER AGEING (6 months) |
|---|---|---|
| Film standard (ex. 1A-comparat) | 42 | 33 |
| Modified film (Ex. 1B) | 50 | 42 |

The surface tension limit to obtain a good adhesion of inks, laminating adhesives, etc. was found to be of the order of 36 mN/m (dyne/cm) as minimum value.

It is clear how the modified film warrants clearly higher and more durable wettability levels of the metal.

### EXAMPLE 2

### EXAMPLE 2A

A coextruded bioriented polypropylene film having a total thickness of 15 micron, was produced by utilizing in the core layer an homopolymer of M.I.= 2,8 g/10 min, (EXXON^{(R)} 4352 E1). The content of extractibles in hexane, at the test indicated above, was lower than 5% by weight. The skin layers, having a thickness of 0.6 microns, were made of a copolymer with M.I. = = 5.2 g/10 min, commercially known as NOBLEN^{(R)} WF 825 of Sumitomo Chemical KK, its content in extractibles in hexane was lower than 2% by weight.

The film was surface treated with 40 W/cm discharge, and was then vacuum metallised until an optical density equal to 2.0 - 2.2 was reached such as to warrant oxygen barrier levels of about 80-100 cm³/24 h. atm. m², measured according to the method ASTM D 3985.

### EXAMPLE 2B (for reference)

The reference film is a coextruded bioriented polypropyylene equal to that of example 1A having a total thickness of 15 micron. The film was metallized with the same modalities of example 2A.

### FILMS CONVERTING AND CHARACTERIZATION

Both films of examples 2A and 2B were submitted to an ageing of 3 months at 20°C - 50% relative humidity, simulating the typical European storage conditions.

The two films were then laminated to a second film with a polyurethane 2-component lamination adhesive (ADCOTE^{(R)} 700 A/C 2) with a coating weight of 3.5 g/m² of solid, commercialized by Morton Chemical.

The second film was a commercially available coextruded bioriented polypropylene film having a thickness of 20 micron (BIMO, STILAN^{(R)} BS20), reverse printed in 6 colours on a rotogravure press, with inks based on modified nitrocellulose, additivated with adhesion promoters (titanium acetylacetonate).

This test simulated the production of a normal flexible packaging structure for snacks or chips.

After 2 weeks (the lamination adhesive cures in about 48-72 hours), the so produced laminates were submitted to delamination tests.

25 mm wide strips were cut with a laboratory cutter, the 2 layers separated by hand and their bond strength was measured by an INSTRON dynamometer.

The results, expressed in g_{force}/25 mm on an average of 10 samples of the 2 laminates are reported in Table 2.

**TABLE 2**

| | Bond strength |
|---|---|
| Film standard (ex. 2B-comparat) | 250-280 |
| Modified film (Ex. 2A) | 600-700 |

The data show that the modified film has a bond strength about twice than that of the standard film.

Moreover in some samples of the laminate obtained with metallized standard films, the metal is completely removed and transferred onto the printed film.

On the contrary, the laminate obtained with the metallized modified film of the present invention shows a very high bond strength. 2 specimens out of 10 have even torn in some points, making the measurement of the bond strength impossible.

### EXAMPLE 3

### EXAMPLE 3A (comparative)

A coextruded bioriented polypropylene film (OPP) having structure similar to example 1A, total thickness 35 micron, thickness of the skin layers 1.2 micron, was submitted to decorative metallization with low optical density (1.5-1.8) and surface printed with an aqueous primer (R 9620089 of ROTORAMA/TOTAL INKS) and inks for outside print based on modified nitrocellulose, (RAMATHERM^{(R)} serie of ROTORAMA/TOTAL INKS).

### EXAMPLE 3B

Example 3A was repeated using an OPP coextruded modified film of example 1B according to the present Invention and having a total thickness of 35 micron, thickness of the skin layers 1.2 microns: then subsequent metallization and printing under the same conditions of example 3A.

As a skin layer the copolymer NOBLEN^{®} WF 8.25 (M.L=5.2 g/10 min commercialized by Sumitomo Chemical KK) was used. This copolymer has the extractability characteristics indicated in example 2.A.

As a core layer a commercial product MOPLEN^{®} S28F was utilized. Its characteristics are indicated in example 1B.

### FILMS CONVERTING AND CHARACTERIZATION

In both cases, after metallization and prior to printing, the film was aged in moderate humidity and temperature conditions: 60% relative humidity and 25°C for 2 months.

These kinds at flexible wrapping, of wide use as wrappers of chocolate Easter eggs or wrappers for gifts, were submitted to adhesion tests with reference adhesive tape (TESA DRG 1112) according to the method described hereunder.

The reference tape is put into contact with and let adhere to the film to be tested with a pressure of 2.5 kg/ cm² by a roll.

Then, the reference tape is removed by manual traction at a rate of about 100 mm/min, orthogonally to the surface.

In the case of the standard film the reference tape removes the Ink and the primer from the undertying metal surface.

On the contrary, in the case of the modified film, the adhesion of the ink layer is excellent.

In a repeated bending test (GELBO Test according to MIL C 9959, MIL F 22191 A, MIL B 131 D) methods), the number of necessary cycles to lead to flex-craciding of the printed layer are, in the two cases:

| | |
|---|---|
| Standard film (ex. 3A-comparative) | 500 cycles |
| Modified film (ex. 3B) | 10000 cycles. |

## Claims

1. Process for the preparation of a printed and/or laminated metallized plastic film comprising the following consecutive steps:
a) coextrusion of a plastic film comprising as surface layers a copolymer based on propylene, containing linear or branched comonomers from 4 to 8 carbon atoms and, optionally, ethylene, said copolymer containing a concentration of extractables in n-hexane at 50°C for 2 hours lower than 5.5% by weight and, as a core layer of the film, a homopolymer of propylene having a content of extractables in hexane at 50°C for 2 hours lower than 10% by weight
b) surface treatment followed by a vacuum metallization process
c) printing and/or lamination of the metal layer of the film after storage of the metallized film for at least one month

2. Process according to claim 1 wherein the film is printed or laminated after storage for at least 3 months.

3. Process according to claim 1 wherein the film is printed or laminated after storage for at least 6 months.

4. Process according to claims 1-3 wherein the copolymer based on propylene contains α-olefins selected from butene, hexene, octene or mixture thereof in amounts from 0.5 to 6% by moles, ethylene in amounts of 0 to 10% by moles and cyclopentadiene and/or terpene in amounts from 0 to 5% by moles.

5. A coextruded, surface treated, vacuum metallised plastic film comprising as a core layer a polymer of propylene having a content of extractables in n-hexane at 50°C for 2 hours lower than 10% by weight and on each side of said core layer a layer of a copolymer based on propylene, containing linear or branched comonomers from 4 to 8 carbon atoms, said copolymer containing a concentration of extractables in n-hexane at 50% for 2 hours lower than 5.5% by weight, **characterised in that** the core layer is a homopolymer of propylene, and the film comprises a printed layer, optionally laminated layer onto the metal layer, whereby the age of the metal layer exceeds the age of the printed layer, optionally laminated by at least one month.

## Patentansprüche

1. Verfahren zur Herstellung einer bedruckten und/oder laminierten metallisierten Kunststoffolie, umfassend die folgenden aufeinanderfolgenden Schritte:
a) Coextrudieren einer Kunststoffolie, die als Oberflächenschichten ein auf Propylen basierendes Copolymer, das lineare oder verzweigte Comonomere von 4 bis 8 Kohlenstoffatomen und gegebenenfalls Ethylen enthält, wobei das Copolymer eine Konzentration an während 2 Stunden bei 50°C in n-Hexan extrahierbaren Stoffen von weniger als 5,5 Gew.-% enthält, und als eine Kernschicht der Folie ein Homopolymer von Propylen mit einem Gehalt an während 2 Stunden bei 50°C in Hexan extrahierbaren Stoffen von weniger als 10 Gew. -% umfasst
b) Oberflächenbehandeln, gefolgt von einem Vakuummetallisierungsverfahren
c) Bedrucken und/oder Laminieren der Metallschicht der Folie nach einem Lagern der metallisierten Folie während mindestens eines Monates.

2. Verfahren nach Anspruch 1, wobei die Folie nach einer Lagerung während mindestens 3 Monate bedruckt und/oder laminiert wird.

3. Verfahren nach Anspruch 1, wobei die Folie nach einer Lagerung während mindestens 6 Monate bedruckt und/oder laminiert wird.

4. Verfahren nach den Ansprüchen 1-3, wobei das auf Propylen basierende Copolymer aus Buten, Hexen, Octen oder Mischungen davon ausgewählte α-Olefine in Mengen von 0,5 bis 6 Mol-%, Ethylen in Mengen von 0 bis 10 Mol-% und Cyclopentadien und/oder Terpen in Mengen von 0 bis 5 Mol-% enthält.

5. Coextrudierte, oberflächenbehandelte, vakuummetallisierte Kunststoffolie, die als eine Kernschicht ein Polymer von Propylen mit einem Gehalt an während 2 Stunden bei 50°C in Hexan extrahierbaren Stoffen von weniger als 10 Gew.-% und auf jeder Seite der Kernschicht eine Schicht eines auf Propylen basierenden Copolymers, das lineare oder verzweigte Comonomere von 4 bis 8 Kohlenstoffatomen enthält, umfasst, wobei das Copolymer eine Konzentration an während 2 Stunden bei 50°C in n-Hexan extrahierbaren Stoffen von weniger als 5,5 Gew.-% enthält,
**dadurch gekennzeichnet, dass**
die Kernschicht ein Homopolymer von Propylen ist und die Folie eine Druckschicht freigestellte laminierte Schicht auf der Metallschicht umfasst, wobei das Alter der Metallschicht um mindestens einen Monat über das Alter der Druckschicht freigestellter laminierten Schicht hinausgeht.

## Revendications

1. Procédé pour la préparation d'un film de matière plastique métallisé imprimé et/ou stratifié comprenant les étapes consécutives suivantes:
a) une coextrusion d'un film de matière plastique comprenant en tant que couches superficielles un copolymère à base de propylène, contenant des comonomères linéaires ou ramifiés ayant 4 à 8 atomes de carbone et, éventuellement, d'éthylène, ledit copolymère contenant une concentration de matières extractibles dans du n-hexane à 50°C pendant 2 heures inférieure à 5,5% en poids et, en tant que couche de coeur du film, un homopolymère de propylène ayant une teneur en matières extractibles dans de l'hexane à 50°C pendant 2 heures inférieure à 10% en poids,
b) un traitement de surface suivi d'un traitement de métallisation sous vide,
c) une impression et/ou stratification de la couche métallique du film après stockage du film métallisé pendant au moins un mois.

2. Procédé selon la revendication 1, dans lequel le film est imprimé ou stratifié après stockage pendant au moins 3 mois.

3. Procédé selon la revendication 1, dans lequel le film est imprimé ou stratifié après stockage pendant au moins 6 mois.

4. Procédé selon les revendications 1 - 3, dans lequel le copolymère à base de propylène contient des α-oléfines sélectionnées parmi le butène, l'hexène, l'octène ou des mélanges de ceux-ci à raison de 0,5 à 6% en moles, l'éthylène à raison de 0 à 10% en moles et le cyclopentadiène et/ou le terpène à raison de 0 à 5% en moles.

5. Film de matière plastique coextrudé, surface traité, métallisé sous vide, comprenant en tant que couche de coeur un polymère de propylène ayant une teneur en matières extractibles dans de l'hexane à 50°C pendant 2 heures inférieure à 10% en poids et, de chaque côté de ladite couche de coeur, une couche d'un copolymère à base de propylène, contenant des comonomères linéaires ou ramifiés ayant de 4 à 8 atomes de carbone ledit copolymère contenant une concentration de matières extractibles dans du n-hexane à 50°C pendant 2 heures inférieure à 5,5% en poids, **caractérisé en ce que** la couche de coeur est un homopolymère de propylène, et **en ce que** le film comprend une couche d'impression optionnellement une couche stratifiée sur la couche métallique, dans lequel que l'age de la couche métallique est supérieur d'au moins un mois à l'age de la couche d'impression optionnellement stratifiée.
